# EUROPEAN PATENT APPLICATION

(11) **EP 4 567 165 A1**
(43) Date of publication of application: **11.06.2025**
(21) Application number: 23849777.0
(22) Date of filing: 20.06.2023
(51) Int. Cl.: C30B 29/36, C30B 25/18, C30B 33/06

(54) **METHOD FOR MANUFACTURING 3C-SIC LAMINATED SUBSTRATE, 3C-SIC LAMINATED SUBSTRATE, AND 3C-SIC INDEPENDENT SUBSTRATE**

(30) Priority: 03.08.2022 JP 2022124317
(71) Applicant: Shin-Etsu Handotai Co., Ltd., Tokyo 100-0004 (JP)
(72) Inventor: OHTSUKI Tsuyoshi, Nishishirakawa-gun, Fukushima 961-8061 (JP); MATSUBARA Toshiki, Nishishirakawa-gun, Fukushima 961-8061 (JP); SUZUKI Atsushi, Nishishirakawa-gun, Fukushima 961-8061 (JP); ABE Tatsuo, Nishishirakawa-gun, Fukushima 961-8061 (JP)
(74) Representative: Sonnenhauser, Thomas Martin
(86) International application number: PCT/JP2023/022801
(87) International publication number: WO 2024/029217

(57) **Abstract**

The present invention is a method for manufacturing a 3C-SiC laminate substrate, the method includes the steps of epitaxially growing a 3C-SiC single crystal film on a first single crystal silicon substrate, bonding a support substrate on an upper surface of the 3C-SiC single crystal film, and removing the first single crystal silicon substrate to manufacture the 3C-SiC laminate substrate. Therefore, an object is to provide a method for manufacturing a 3C-SiC laminate substrate. In particular, this provides a method for obtaining a 3C-SiC laminate substrate having a large diameter such as 200 mmϕ or 300 mmϕ.

## Description

### TECHNICAL FIELD

The present invention relates to a method for manufacturing a 3C-SiC laminate substrate, a 3C-SiC laminate substrate, and a freestanding 3C-SiC substrate.

### BACKGROUND ART

SiC has a wide bandgap of 2.2 to 3.3 eV which gives a high dielectric breakdown strength and high thermal conductivity, making it a promising material as a semiconductor material for various semiconductor devices such as power devices and high-frequency devices. In addition, although SiC is known for having different crystal structures such as 3C, 4H, and 6H, 3C is a cubic crystal and is known as a promising material for devices in which orientation dependence is absent.

With such a background, 3C-SiC growth has been studied for a long time, where bulk growth (see, Non Patent Documents 1 and 2), and heteroepitaxial growth (Non Patent Document 3 discloses early heteroepitaxial growth, and Patent Documents 1 to 5 disclose recent heteroepitaxial growth on a silicon substrate) are known. When summarizing these previous researches and patents, (1) high-temperature (higher than 1500°C) is required for the bulk growth, resulting in great difficulty in enlarging a diameter applicable to devices, (2) on the other hand, high-temperature as in 4H or 6H (higher than 1500°C) is not required in epitaxial growth, enabling the growth approximately at a temperature of 1100°C, thus the growth on the silicon substrate is also possible which is advantageous in terms of enlarging the diameter.

Based on these findings, research has been conducted for heteroepitaxially growing 3C-SiC and leaving only 3C-SiC epitaxial film (Non Patent Document 4). In this method, a 2-inch freestanding 3C-SiC substrate is manufactured by growing approximately 100 µm of 3C-SiC on a Si (111) substrate and then removing Si using nitrohydrofluoric acid.

In order to realize this method in large-diameter substrates, it is necessary to grow thick SiC. When considering defect generation due to the difference in lattice constant and the difference in coefficient of linear expansion, thick film forming on Si is accompanied with difficulty and only small-diameter substrates such as 4H and 6H can likely be obtained.

### CITATION LIST

### PATENT LITERATURE

Patent Document 1: JP 2018-522412 A
Patent Document 2: JP 2021-20819 A
Patent Document 3: JP 2006-253617 A
Patent Document 4: JP 2008-184361 A
Patent Document 5: JP 2017-39622 A

### NON PATENT LITERATURE

Non Patent Document 1: H.Nagasawa, K.Yagi and T.Kawahara: J.Cryst.Growth, 239 (2002) 1244.
Non Patent Document 2: D.Chaussende, F.Mercier, A.Boulle, F.Conchon, M.Soueidan, G.Ferro, A.Mantzari, A.Andreadou, E.K.Polychroniadis, C.Balloud, S.Juillaguet, J.Camassel and M.Pons: J.Cryst.Growth, 310 (2008) 976.
Non Patent Document 3: T.Ujihara, R.Maekawa, R.Tanaka, K.Sasaki, K.Kuroda and Y.Takeda: J.Cryst.Growth, 310 (2008) 1438.
Non Patent Document 4: "Crystal Quality of Free-Standing 3C-SiC (111) Substrates by Low Temperature Growth", the 62nd JSAP Spring Meeting 2015, Extended Abstracts, 13-095 (2015).

### SUMMARY OF INVENTION

### TECHNICAL PROBLEM

The present invention has been made to solve the above-described problem. An object of the present invention is to provide a method for manufacturing a 3C-SiC laminate substrate. In particular, an object is to provide a method for obtaining a 3C-SiC laminate substrate having a large diameter such as a diameter of 200 mm or 300 mm. Moreover, an object is to obtain a 3C-SiC laminate substrate or a freestanding 3C-SiC substrate.

### SOLUTION TO PROBLEM

The present invention has been made to achieve the above objects and provide a method for manufacturing a 3C-SiC laminate substrate, the method comprising the steps of:
epitaxially growing a 3C-SiC single crystal film on a first single crystal silicon substrate;
bonding a support substrate on an upper surface of the 3C-SiC single crystal film; and
removing the first single crystal silicon substrate to manufacture the 3C-SiC laminate substrate.

According to such a method for manufacturing a 3C-SiC laminate substrate, the 3C-SiC laminate substrate, in particular, the 3C-SiC laminate substrate having a large diameter and few defects can be easily and reliably manufactured. This enables to decrease a manufacture cost.

According to such a method, it is possible to manufacture the 3C-SiC laminate substrate with a thin epitaxial film that has few defects, without the need for growing thick SiC. The epitaxially grown substrate is bonded to a support substrate and a first silicon substrate is then delaminated. This releases the epitaxial film from the lattice mismatch of the substrate, reducing the likelihood of defect generation in the 3C-SiC single crystal film.

According to such a method, the manufacture of the 3C-SiC laminate substrate having a large diameter of 200 mm or even 300 mm or larger is enabled by using a silicon substrate having a diameter of 200 mm or larger.

In addition, various substrates are envisaged as the support substrates. A sintered body or polycrystal of SiC, or ceramic is sufficient, and sapphire is sufficient. When considering the low cost and ease of processing, the use of the single crystal silicon substrate is the most suitable.

In particular, when a low-resistance substrate having a high concentration of boron or dopant is used as a substrate for an initial 3C-SiC epitaxial growth, and a high-resistance substrate having a low concentration of boron and dopant is used for the support substrate on the 3C-SiC epitaxial side, the high-resistance substrate is barely etched during nitrohydrofluoric acid etching. On the other hand, the low-resistance substrate has a higher etching rate, enabling thereof to ensure selectivity to remove the low-resistance substrate while retaining the high-resistance substrate. This facilitates the manufacturing of the 3C-SiC laminate substrate.

In this case, the first single crystal silicon substrate can have a resistivity of less than 0.1 Ω·cm.

In this way, when the high-resistance substrate having a low concentration of boron or dopant is used for the support substrate on the 3C-SiC epitaxial side, the high-resistance substrate is barely etched during nitrohydrofluoric acid etching. On the other hand, the low-resistance substrate has a higher etching rate, enabling thereof to ensure selectivity to remove the low-resistance substrate being the first single crystal silicon substrate while retaining the high-resistance substrate being the support substrate. As a result, the 3C-SiC laminate substrate can be manufactured.

In this case, the method for manufacturing a 3C-SiC laminate substrate described above is provided, wherein
the support substrate is either a second single crystal silicon substrate or a substrate in which a diamond is grown on a third single crystal silicon substrate.

Accordingly, the 3C-SiC laminate substrate in which the 3C-SiC single crystal film is laminated on the single crystal silicon substrate and the 3C-SiC single crystal film has a diameter of 200 mm or larger, or the 3C-SiC laminate substrate in which the 3C-SiC single crystal film is laminated on the diamond, can be obtained.

In this case, the method for manufacturing a 3C-SiC laminate substrate described above is provided, wherein
the second single crystal silicon substrate has a resistivity of 500 Ω·cm or higher.

In this way, the high-resistance substrate is barely etched during nitrohydrofluoric acid etching. On the other hand, the low-resistance substrate has a higher etching rate, enabling thereof to ensure selectivity to remove the low-resistance substrate being the first single crystal silicon substrate while retaining the high-resistance substrate being the second single crystal silicon substrate. As a result, the 3C-SiC laminate substrate, in which the 3C-SiC single crystal film is laminated on the single crystal silicon substrate, and the 3C-SiC single crystal film has a diameter of 200 mm or larger, can be obtained.

In this case, the method for manufacturing a 3C-SiC laminate substrate described above is provided, wherein
the third single crystal silicon substrate has a resistivity of less than 0.1 Ω·cm.

This allows, after bonding, the removal of the third single crystal silicon substrate during silicon removal while retaining the diamond,
and obtaining the 3C-SiC laminate substrate in which the 3C-SiC single crystal film is laminated on the diamond.

In this case, the method for manufacturing a 3C-SiC laminate substrate described above is provided, wherein
in a case where the substrate in which the diamond is grown on the third single crystal silicon substrate is used as the support substrate, when the first single crystal silicon substrate is removed, the third single crystal silicon substrate is also removed and the diamond is left, thereby manufacturing the 3C-SiC laminate substrate.

In this way, the 3C-SiC laminate substrate in which the 3C-SiC single crystal film is laminated on the diamond can be efficiently obtained.

In this case, the method for manufacturing a 3C-SiC laminate substrate described above is provided, wherein
the 3C-SiC single crystal film has a diameter of 200 mm or larger.

According to the present invention, the 3C-SiC laminate substrate having such a large diameter can be obtained while also reducing the manufacturing cost.

The present invention provides a 3C-SiC laminate substrate, wherein
a 3C-SiC single crystal film is laminated on a single crystal silicon substrate, and
the 3C-SiC single crystal film has a diameter of 200 mm or larger.

With the 3C-SiC laminate substrate having such a large diameter, manufacturing cost can be reduced.

The present invention provides a 3C-SiC laminate substrate, wherein
a 3C-SiC single crystal film is laminated on a diamond.

According to such a 3C-SiC laminate substrate, manufacturing cost can be reduced. In particular, it is applicable for a power device and a high-frequency device utilizing an excellent heat-dissipating property of diamond.

The present invention provides a 3C-SiC laminate substrate, wherein
a single crystal silicon substrate, a diamond, a 3C-SiC single crystal film, and a single crystal silicon substrate are laminated in this order.

According to such a 3C-SiC laminate substrate, manufacturing cost can be reliably reduced. In particular, it is applicable for a power device and a high-frequency device utilizing an excellent heat-dissipating property of diamond.

The present invention provides the 3C-SiC laminate substrate described above, wherein
the 3C-SiC single crystal film has a diameter of 200 mm or larger.

According to such a 3C-SiC laminate substrate, manufacturing cost can be more reliably reduced.

The present invention provides a freestanding 3C-SiC substrate, the freestanding 3C-SiC substrate being a substrate comprising a 3C-SiC single crystal film, wherein
the 3C-SiC single crystal film has a diameter of 200 mm or larger.

In the present invention, the freestanding 3C-SiC substrate having such a large diameter can be obtained. Therefore, it can be expected to find applications for various devices.

### ADVANTAGEOUS EFFECTS OF INVENTION

As described above, according to the inventive method for manufacturing a 3C-SiC laminate substrate, the 3C-SiC laminate substrate, in particular, the 3C-SiC laminate substrate having a large diameter and few defects can be easily and reliably manufactured.

According to the inventive 3C-SiC laminate substrate, manufacturing cost can be reduced.

According to a configuration of the present invention, a large-diameter freestanding 3C-SiC substrate can be obtained through a simple manufacturing process.

### BRIEF DESCRIPTION OF DRAWINGS

FIG. 1 is a view illustrating an example of a manufacturing flow of a laminate substrate, and a view illustrating a manufacturing flow of a laminate substrate composed of a single crystal silicon substrate and a 3C-SiC.
FIG. 2 is a view illustrating another example of a manufacturing flow of a laminate substrate, and a view illustrating a manufacturing flow of a laminate substrate composed of a single crystal silicon substrate, a diamond, a 3C-SiC, and a single crystal silicon substrate.
FIG. 3 is a view illustrating a further example of a manufacturing flow of a laminate substrate, and a view illustrating a manufacturing flow of a laminate substrate composed of a diamond and a 3C-SiC.
FIG. 4 is a view illustrating an example of a flow diagram for manufacturing a freestanding substrate.
FIG. 5 is a view illustrating an example of a growth sequence of 3C-SiC.
FIG. 6 is a view illustrating a result of an In-plane XRD analysis of a 3C-SiC (111) laminate substrate manufactured in Example 1.
FIG. 7 is a view illustrating a result of an In-plane XRD analysis of a 3C-SiC (111) laminate substrate manufactured in Example 2.

### DESCRIPTION OF EMBODIMENTS

Hereinafter, the present invention will be described in detail. However, the present invention is not limited thereto.

As described above, a method for manufacturing a 3C-SiC laminate substrate, in particular, a method for obtaining a 3C-SiC laminate substrate having a large diameter such as 200 mmϕ or 300 mmϕ, and a method for obtaining a 3C-SiC laminate substrate or a freestanding 3C-SiC substrate have been required.

To solve the above problems, the present inventors have earnestly studied and found out that a 3C-SiC laminate substrate, in particular, a 3C-SiC laminate substrate having a large diameter with few defects can be easily and reliably manufactured by a method for manufacturing a 3C-SiC laminate substrate. This method for manufacturing a 3C-SiC laminate substrate includes the steps of epitaxially growing a 3C-SiC single crystal film on a first single crystal silicon substrate, bonding a support substrate on an upper surface of the 3C-SiC single crystal film, and removing the first single crystal silicon substrate to manufacture the 3C-SiC laminate substrate. Based on this finding, the present invention has been completed.

### (First Embodiment: Manufacturing Flow of Laminate Substrate composed of Single Crystal Silicon Substrate and 3C-SiC)

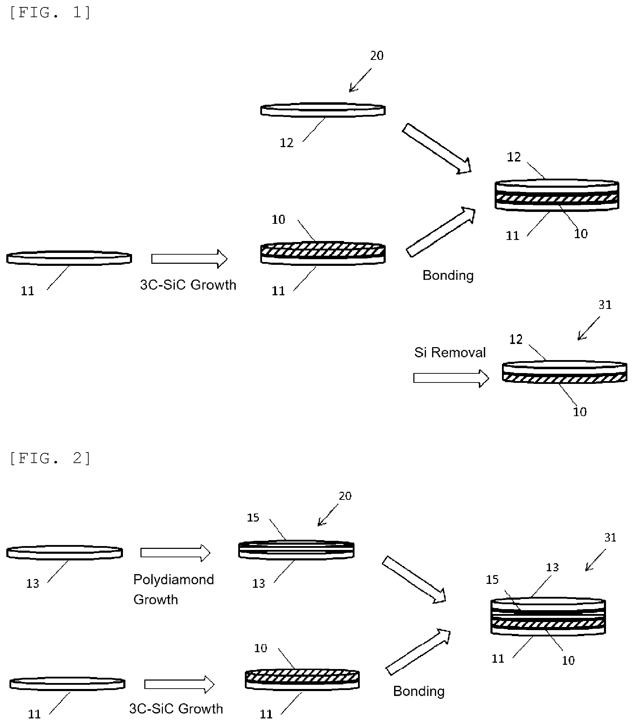

Hereinafter a method for manufacturing a 3C-SiC laminate substrate according to the first embodiment of the present invention is described, referring to FIG. 1.

FIG. 1 is a view illustrating an example of the manufacturing flow of the laminate substrate, and a view illustrating the manufacturing flow of the laminate substrate composed of a single crystal silicon substrate and a 3C-SiC.

The inventive method for manufacturing a 3C-SiC laminate substrate includes the steps of epitaxially growing a 3C-SiC single crystal film 10 on a first single crystal silicon substrate 11, bonding a support substrate 20 on an upper surface of the 3C-SiC single crystal film, and removing the first single crystal silicon substrate 11 to manufacture a 3C-SiC laminate substrate 31.

### (Step of Epitaxially Growing 3C-SiC Single Crystal Film on First Single Crystal Silicon Substrate)

First, the first single crystal silicon substrate 11 (low-resistance substrate: resistivity is preferably 0.001 Ω·cm or higher and less than 0.1 Ω·cm, for example, 0.005 Ω·cm) is placed in a reduced pressure (RP)-CVD apparatus and a native oxide film on a surface is removed by hydrogen baking (H₂ anneal). When an oxide film remains, nucleation of SiC cannot be performed on the first single crystal silicon substrate 11. The H₂ anneal at this time preferably has a condition of a temperature of 1000°C or higher and 1200°C or lower. When the temperature is lower than 1000°C, a prolonged processing time is required to prevent the residual native oxide film. Conversely, the temperature exceeding 1200°C raises concerns about slip generation. A pressure and time for the H₂ annealing at this time are not particularly limited as long as the native oxide film is removed.

In addition, by using the RP-CVD apparatus, it is possible to handle a substrate having a large diameter. In this case, as the first single crystal silicon substrate 11, the substrate having a diameter of 200mm or larger, 450 mm or smaller is used.

Moreover, as the first single crystal silicon substrate 11, a substrate having a thickness of approximately 770 µm is used.

Next, in order to form SiC nuclei on the surface of the first single crystal silicon substrate 11 and subsequently form the 3C-SiC single crystal film, a carbonization gas such as a propane gas or a gas containing carbon and silicon such as trimethylsilane gas is introduced as a raw material gas. The temperature thereof is then gradually raised from a temperature in a range of 300°C or higher and 950°C or lower to a temperature in a range of 1000°C or higher and lower than 1200°C. A growth rate is in a range of 0.5 to 5°C/min, and approximately 1°C/min is preferable. At this point, after the temperature is raised to a predetermined temperature, the growth may either be stopped or continued until reaching a predetermined film thickness. Alternatively, when reaching the predetermined film thickness during the temperature rise, the growth may be stopped at that point. By growing with changing the temperature, a gradual increase in a film-forming rate is enabled by continuously changing a growth mode. This forms the SiC single crystal film 10.

### (Step of Bonding Support Substrate on Upper Surface of 3C-SiC Single Crystal Film)

Next, the support substrate 20 having the same diameter is provided, and bonding therebetween is performed. While a second single crystal silicon substrate 12 (high-resistance substrate: a resistivity thereof is preferably 500 Ω·cm or higher and 10000 Ω·cm or lower, for example, larger than 1000 Ω·cm) is bonded as the support substrate 20, at this time, a surface of the 3C-SiC substrate 10 described above may be bonded to the support substrate 20 as is, or the bonding may be performed after activating the surfaces of the respective substrates by using gases such as O₂, N₂, or O₃ activated by plasma. The bonding strength by heat treatment is further enhanced by processing at 300 to 600°C for a short time after bonding but not mandatory.

### (Step of Removing First Single Crystal Silicon Substrate to Manufacture 3C-SiC Laminate Substrate)

Finally, the first single crystal silicon substrate 11 having low resistance is removed. Silicon having a thickness of approximately 770 µm may be completely etched using nitrohydrofluoric acid, and grinding and polishing may be combined. In the etching using nitrohydrofluoric acid, the low-resistance substrate side has a faster etching rate compared to the high-resistance substrate, only the first single crystal silicon substrate 11 is removed by etching, and the second single crystal silicon substrate 12, being the support substrate 20, is not etched away completely.

According to the above steps, the 3C-SiC laminate substrate 31, in which the 3C-SiC single crystal film 10 is laminated on the single crystal silicon substrate 12 and the 3C-SiC single crystal film has a diameter of 200 mm or larger, can be obtained.

### (Second Embodiment: Manufacturing Flow of Laminate Substrate composed of Single Crystal Silicon Substrate, Diamond, 3C-SiC, and Single Crystal Silicon Substrate)

FIG. 2 is a view illustrating another example of the manufacturing flow of a laminate substrate, and a view illustrating the manufacturing flow of the laminate substrate composed of a single crystal silicon substrate, a diamond, a 3C-SiC, and a single crystal silicon substrate.

The second embodiment has the same configuration as the first embodiment except that, a support substrate 20 in which a diamond 15 is grown on a third single crystal silicon substrate 13 is used instead of a second single crystal silicon substrate 12 as a support substrate 20, and the single crystal silicon substrate is not removed after bonding.

The support substrate 20 having the same diameter as a first single crystal silicon substrate 11 is provided. The support substrate 20 is a substrate in which the diamond 15 is grown on the third single crystal silicon substrate 13. For example, this substrate is formed by growing the diamond 15 on the third single crystal silicon substrate 13 by a hot-filament method.

Bonding is performed using this support substrate 20. N₂ plasma is used when bonding. When O₂ or O₃ is used, the diamond is vaporized by oxidation.

By the above steps, the single crystal silicon substrate 13, the diamond 15, a 3C-SiC single crystal film 10, and the single crystal silicon substrate 11 are laminated in this order, and then a 3C-SiC laminate substrate 31 is obtained. The 3C-SiC single crystal film 10 preferably has a diameter of 200 mm or larger and 450 mm or smaller. Since a configuration in which the 3C-SiC single crystal film 10 on the diamond 15 with high thermal conductivity is laminated, it can be applied to a power device or a high-frequency device.

It is needless to say the first single crystal silicon substrate may be removed to make a three-layer laminate substrate, depending on the purpose.

### (Third Embodiment: Manufacturing Flow of Laminate Substrate composed of Diamond and 3C-SiC)

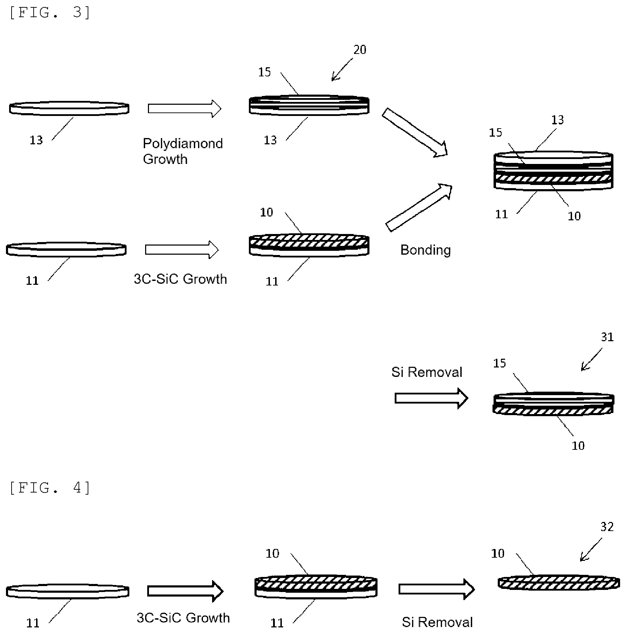

FIG. 3 is a view illustrating a further example of the manufacturing flow of a laminate substrate, and a view illustrating the manufacturing flow of the laminate substrate composed of a diamond and a 3C-SiC.

The third embodiment has the same configuration as the second embodiment except that a first and a third single crystal silicon substrate are removed after bonding.

3C-SiC laminate substrate can be obtained, in which a single crystal silicon substrate, a diamond, a 3C-SiC single crystal film, and a single crystal silicon substrate are laminated in this order, by bonding in the same configuration as in the second embodiment.

Both single crystal silicon substrates are removed after bonding. At that time, only low-resistance silicon can be etched when nitrohydrofluoric acid is used. Consequently, by making not only a first single crystal silicon substrate 11 but also a third single crystal silicon substrate 13 into the low-resistance substrates (preferably, a resistivity is 0.001 Ω·cm or higher and less than 0.1 Ω·cm, for example, 0.005 Ω·cm), then after bonding, not only the first single crystal silicon substrate 11 but also the third single crystal silicon substrate 13 can be removed.

By the above steps, the 3C-SiC single crystal film 10 is laminated on the diamond 15, and then a 3C-SiC laminate substrate 31 is obtained. The 3C-SiC single crystal film 10 preferably has a diameter of 200 mm or larger and 450 mm or smaller. Since a configuration is composed of the 3C-SiC single crystal film 10 laminated on the diamond 15 with high thermal conductivity, it can be applied to a power device or a high-frequency device.

### (Fourth Embodiment: Manufacturing Flow of Freestanding Substrate)

FIG. 4 is a view illustrating an example of a flow diagram for manufacturing a freestanding substrate.

First, a first single crystal silicon substrate 11 (low-resistance substrate: resistivity is preferably 0.001 Ω·cm or higher and less than 0.1 Ω·cm, for example, 0.005 Ω·cm) is placed in a reduced pressure (RP)-CVD apparatus and a native oxide film on a surface is removed by hydrogen baking (H₂ anneal). When an oxide film remains, nucleation of SiC cannot be performed on the first single crystal silicon substrate 11. The H₂ anneal at this time preferably has a condition of a temperature of 1000°C or higher and 1200°C or lower. When the temperature is lower than 1000°C, a prolonged processing time is required to prevent the residual native oxide film. Conversely, the temperature exceeding 1200°C raises concerns about slip generation. A pressure and time for the H₂ annealing at this time are not particularly limited as long as the native oxide film is removed.

In addition, by using the RP-CVD apparatus, it is possible to handle a substrate having a large diameter. In this case, as the first single crystal silicon substrate 11, a substrate having a diameter of 200mm or larger and 450 mm or smaller is used.

Moreover, as the first single crystal silicon substrate 11, a substrate having a thickness of approximately 770 µm is used.

Next, in order to form SiC nuclei on the surface of the first single crystal silicon substrate 11 and subsequently form a 3C-SiC single crystal film, while a carbonization gas such as propane gas is introduced as a raw material gas, the temperature thereof is then gradually raised from a temperature in a range of 300°C or higher and 950°C or lower to a temperature in a range of 1000°C or higher and lower than 1200°C. A growth rate is in a range of 0.5 to 5°C/min, and approximately 1°C/min is preferable. At this point, after the temperature is raised to a predetermined temperature, the growth may either be stopped or continued until reaching a predetermined film thickness. Alternatively, when reaching the predetermined film thickness during the temperature rise, the growth may be stopped at that point. By growing with changing the temperature, a gradual increase in a film-forming rate is enabled by continuously changing a growth mode. This forms a 3C-SiC single crystal film 10.

Finally, the first single crystal silicon substrate 11 (low-resistance substrate: resistivity is preferably 0.001 Ω·cm or higher and less than 0.1 Ω·cm, for example, 0.005 Ω·cm) is removed. Silicon having a thickness of approximately 770 µm may be completely etched using nitrohydrofluoric acid, and grinding and polishing may be combined.

With the above steps, a freestanding 3C-SiC substrate 32, being a substrate composed of the 3C-SiC single crystal film 10 where the 3C-SiC single crystal film has a diameter of 200 mm or larger, can be obtained.

### EXAMPLE

Hereinafter, the present invention will be specifically described with reference to Examples. However, the present invention is not limited thereto.

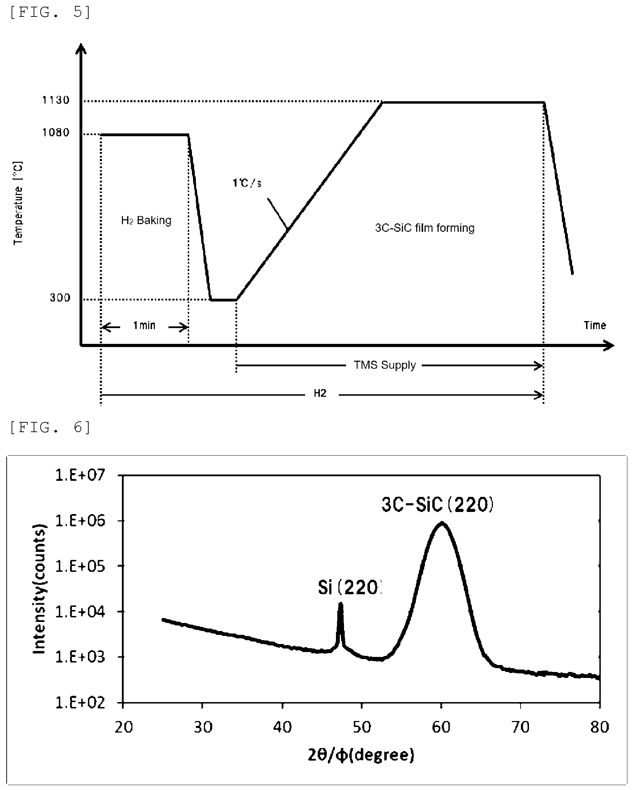

FIG. 5 is a view illustrating an example of a growth sequence of 3C-SiC. 3C-SiC growths in Examples 1 and 2 were performed according to the growth sequence of 3C-SiC shown in FIG. 5.

### (Example 1)

First, a boron-doped single crystal silicon (111) substrate having low resistance (resistivity: 0.005 Ω·cm, hereinafter also referred to as "wafer") and a diameter of 300 mm was provided. The wafer was placed on a susceptor in a reaction furnace of an RP-CVD apparatus and then H₂ anneal was performed at 1080°C for 1 minute.

Subsequently, after lowering the temperature in the furnace to 300°C, trimethylsilane gas was introduced while raising the temperature to 1130°C at a temperature rise rate of 1°C/sec, and nucleation of SiC and subsequent formation of a 3C-SiC single crystal film were performed. A growth pressure at this time was set to 100 Torr (13332.2 Pa) uniformly. After reaching 1130°C, the temperature was held for 10 minutes, and the growth of the 3C-SiC single crystal film was performed (film thickness: 200 nm).

After film-forming, a boron-doped single crystal silicon (111) substrate having high resistance (resistivity: 1000 Ω·cm) and a diameter of 300 mm was provided. Both bonding surfaces of the silicon and the 3C-SiC were irradiated with N₂ plasma (250 Torr (33330.6 Pa), N₂: 300 sccm, RF power 100 W, 10 minutes), then bonded to each other.

Subsequently, the single crystal silicon substrate on the low-resistance side was removed by immersion in a nitrohydrofluoric acid solution (H₂O: HF: HNO₃=5: 1: 1).

The 3C-SiC film was then confirmed by XRD in an In-plane arrangement.

FIG. 6 is a view illustrating a result of an In-plane XRD analysis of a 3C-SiC (111) laminate substrate manufactured in Example 1.

As shown in FIG. 6, a peak of 3C-SiC(220) parallel to Si(220) was successfully confirmed, and the growth of the 3C-SiC film of a single crystal was confirmed.

### (Example 2)

First, a boron-doped single crystal silicon (111) substrate having low resistance (resistivity: 0.005 Ω·cm, hereinafter also referred to as "wafer") having a diameter of 300 mm was provided. The wafer was placed on a susceptor in a reaction furnace of an RP-CVD apparatus and then H₂ anneal was performed at 1080°C for 1 minute.

Subsequently, after lowering the temperature in the furnace to 300°C, trimethylsilane gas was introduced while raising the temperature to 1130°C at a temperature rise rate of 1°C/sec, and a nucleation step of SiC and subsequent formation of a 3C-SiC single crystal film were performed. A growth pressure at this time was set to 100 Torr (13332.2 Pa) uniformly. After reaching 1130°C, the temperature was held for 10 minutes, and the growth of the 3C-SiC single crystal film was performed (film thickness: 200 nm).

On the other hand, a boron-doped single crystal silicon (111) substrate having low resistance (resistivity: 0.005 Ω·cm) and a diameter of 300 mm was provided. Polydiamond was then grown thereon for 100 µm by a hot-filament CVD apparatus (5 Torr (666.612 Pa), filament temperature: 2250°C, CH₄: 1%).

Next, both bonding surfaces of the silicon and the 3C-SiC were irradiated with N₂ plasma (250 Torr (33330.6 Pa), N₂: 300 sccm, RF power 100 W, 10 minutes), then bonded to each other.

Subsequently, all of the single crystal silicon substrates having low resistance were removed by immersion in a nitrohydrofluoric acid solution (H₂O: HF: HNO₃=5: 1: 1).

The 3C-SiC film was then confirmed by XRD in an In-plane arrangement.

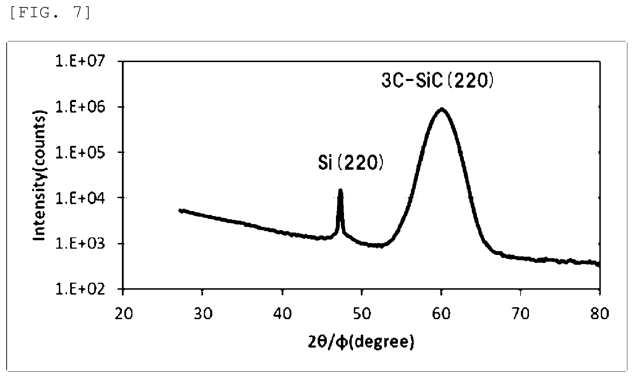

FIG. 7 is a view illustrating a result of an In-plane XRD analysis of a 3C-SiC (111) laminate substrate manufactured in Example 2.

As shown in FIG. 7, a peak of 3C-SiC(220) parallel to Si(220) was successfully confirmed, and the growth of the 3C-SiC film of a single crystal was confirmed.

As described above, according to Examples of the present invention, the 3C-SiC laminate substrate having a large diameter and few defects was successfully manufactured in an easy and reliable manner.

The present description includes the following embodiments.
[1]: A method for manufacturing a 3C-SiC laminate substrate, the method comprising the steps of:
   epitaxially growing a 3C-SiC single crystal film on a first single crystal silicon substrate;
   bonding a support substrate on an upper surface of the 3C-SiC single crystal film; and
   removing the first single crystal silicon substrate to manufacture the 3C-SiC laminate substrate.
[2]: The method for manufacturing a 3C-SiC laminate substrate according to the above [1], wherein
   the first single crystal silicon substrate has a resistivity of less than 0.1 Ω·cm.
[3]: The method for manufacturing a 3C-SiC laminate substrate according to the above [1] or [2], wherein
   the support substrate is either a second single crystal silicon substrate or a substrate in which a diamond is grown on a third single crystal silicon substrate.
[4]: The method for manufacturing a 3C-SiC laminate substrate according to the above [3], wherein
   the second single crystal silicon substrate has a resistivity of 500 Ω·cm or higher.
[5]: The method for manufacturing a 3C-SiC laminate substrate according to the above [3], wherein
   the third single crystal silicon substrate has a resistivity of less than 0.1 Ω·cm.
[6]: The method for manufacturing a 3C-SiC laminate substrate according to the above [3] or [5], wherein
   in a case where the substrate in which the diamond is grown on the third single crystal silicon substrate is used as the support substrate, when the first single crystal silicon substrate is removed, the third single crystal silicon substrate is also removed and the diamond is left, thereby manufacturing the 3C-SiC laminate substrate.
[7]: The method for manufacturing a 3C-SiC laminate substrate according to any one of the above [1] to [6], wherein
   the 3C-SiC single crystal film has a diameter of 200 mm or larger.
[8]: A 3C-SiC laminate substrate, wherein
   a 3C-SiC single crystal film is laminated on a single crystal silicon substrate, and
   the 3C-SiC single crystal film has a diameter of 200 mm or larger.
[9]: A 3C-SiC laminate substrate, wherein
   a 3C-SiC single crystal film is laminated on a diamond.
[10]: A 3C-SiC laminate substrate, wherein
   a single crystal silicon substrate, a diamond, a 3C-SiC single crystal film, and a single crystal silicon substrate are laminated in this order.
[11]: The 3C-SiC laminate substrate according to claim 9 or 10, wherein
   the 3C-SiC single crystal film has a diameter of 200 mm or larger.
[12]: A freestanding 3C-SiC substrate, the freestanding 3C-SiC substrate being a substrate comprising a 3C-SiC single crystal film, wherein
   the 3C-SiC single crystal film has a diameter of 200 mm or larger.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for manufacturing a 3C-SiC laminate substrate, the method comprising the steps of:
epitaxially growing a 3C-SiC single crystal film on a first single crystal silicon substrate;
bonding a support substrate on an upper surface of the 3C-SiC single crystal film; and
removing the first single crystal silicon substrate to manufacture the 3C-SiC laminate substrate.

2. The method for manufacturing a 3C-SiC laminate substrate according to claim 1, wherein
the first single crystal silicon substrate has a resistivity of less than 0.1 Ω·cm.

3. The method for manufacturing a 3C-SiC laminate substrate according to claim 1, wherein
the support substrate is either a second single crystal silicon substrate or a substrate in which a diamond is grown on a third single crystal silicon substrate.

4. The method for manufacturing a 3C-SiC laminate substrate according to claim 3, wherein
the second single crystal silicon substrate has a resistivity of 500 Ω·cm or higher.

5. The method for manufacturing a 3C-SiC laminate substrate according to claim 3, wherein
the third single crystal silicon substrate has a resistivity of less than 0.1 Ω·cm.

6. The method for manufacturing a 3C-SiC laminate substrate according to claim 3, wherein
in a case where the substrate in which the diamond is grown on the third single crystal silicon substrate is used as the support substrate, when the first single crystal silicon substrate is removed, the third single crystal silicon substrate is also removed and the diamond is left, thereby manufacturing the 3C-SiC laminate substrate.

7. The method for manufacturing a 3C-SiC laminate substrate according to claim 1, wherein
the 3C-SiC single crystal film has a diameter of 200 mm or larger.

8. A 3C-SiC laminate substrate, wherein
a 3C-SiC single crystal film is laminated on a single crystal silicon substrate, and
the 3C-SiC single crystal film has a diameter of 200 mm or larger.

9. A 3C-SiC laminate substrate, wherein
a 3C-SiC single crystal film is laminated on a diamond.

10. A 3C-SiC laminate substrate, wherein
a single crystal silicon substrate, a diamond, a 3C-SiC single crystal film, and a single crystal silicon substrate are laminated in this order.

11. The 3C-SiC laminate substrate according to claim 9 or 10, wherein
the 3C-SiC single crystal film has a diameter of 200 mm or larger.

12. A freestanding 3C-SiC substrate, the freestanding 3C-SiC substrate being a substrate comprising a 3C-SiC single crystal film, wherein
the 3C-SiC single crystal film has a diameter of 200 mm or larger.
